# EUROPEAN PATENT APPLICATION

(11) **EP 4 839 061 A1**
(43) Date of publication of application: **11.11.2026**
(21) Application number: 25776295.5
(22) Date of filing: 12.03.2025
(51) Int. Cl.: H10F 77/30

(54) **SOLAR CELL MANUFACTURING METHOD, SOLAR CELL, AND PHOTOVOLTAIC MODULE**

(30) Priority: 29.03.2024 CN 202410377188; 28.04.2024 CN 202410522507; 13.12.2024 CN 202411841552; 13.12.2024 CN 202411841551
(71) Applicant: CSI Cells (YangZhou) Co., Ltd., Yangzhou, Jiangsu 225001 (CN)
(72) Inventor: LAI, Junnan, Yangzhou, Jiangsu 225001 (CN); CHEN, Haiyan, Yangzhou, Jiangsu 225001 (CN); YE, Xiaoya, Yangzhou, Jiangsu 225001 (CN); DENG, Weiwei, Yangzhou, Jiangsu 225001 (CN)
(74) Representative: karo IP
(86) International application number: PCT/CN2025/082050
(87) International publication number: WO 2025/201052

(57) **Abstract**

A method for preparing a solar cell, a solar cell, and a photovoltaic module are disclosed. The preparing method includes the following steps: providing a silicon substrate, the silicon substrate including a first surface and a second surface that are disposed opposite to each other, the second surface including a first region and a second region distributed at intervals; forming a tunneling layer and a second doped layer that are stacked on the first region; preparing a second passivation layer on the second region and the second doped layer, the second passivation layer being in contact with the silicon substrate on the second region; and preparing a second electrode on the first region, the second electrode being in contact with the second doped layer.

## Description

### CROSS-REFERENCE TO RELATED APPLICATIONS

The present application claims priorities to Chinese patent application No. 202411841552.5 entitled "SOLAR CELL AND PHOTOVOLTAIC MODULE" and filed with the China National Intellectual Property Administration on December 13, 2024, Chinese patent application No. 202410377188.5 entitled "METHOD FOR PREPARING SOLAR CELL" and filed with the China National Intellectual Property Administration on March 29, 2024, Chinese patent application No. 202411841551.0 entitled "METHOD FOR PREPARING SOLAR CELL" and filed with the China National Intellectual Property Administration on December 13, 2024, Chinese patent application No. 202410522507.7 entitled "METHOD FOR PREPARING SOLAR CELL" and filed with the China National Intellectual Property Administration on April 28, 2024, which are hereby incorporated by reference in their entireties.

### TECHNICAL FIELD

The present disclosure relates to the technical field of solar cells, and more particularly, to a method for preparing a solar cell, a solar cell, and a photovoltaic module.

### BACKGROUND

With the rapid development of the photovoltaic industry, performance and efficiency requirements for solar cells in both domestic and international markets continue to rise. Industry manufacturers are focusing on research and development of high-efficiency cells. Tunnel Oxide Passivated Contact (TOPCon) cells can improve surface passivation performance of the cells and reduce a metal contact recombination current by sequentially preparing an ultra-thin tunneling oxide layer and a doped polysilicon layer on a back surface of a silicon substrate, which effectively improves an open-circuit voltage and a short-circuit current of the cells. In recent years, the market share of the TOPCon cells has grown rapidly, and has gradually surpassed Passivated Emitter Rear Cells (PERCs) to become the mainstream technology of the solar cells.

In TOPCon cells, both the n+ polarity and p+ polarity have excellent passivation and conductive properties, and are also compatible with traditional industrial production, offering broad prospects for development. With the continuous optimization of TOPCon cells, the parasitic absorption of the back-surface polysilicon layer (poly) has become the primary factor limiting the improvement of TOPCon cell efficiency and bifaciality.

In TOPCon cells, the back-surface polysilicon layer forms a doped polysilicon layer (N+ Poly) after phosphorus doping, which mainly has three functions as follows: 1. providing a field passivation effect; 2. acting as a phosphorus-rich layer that greatly improves the back-surface contact; 3. preventing direct contact between the Ag metal and the silicon substrate, reducing metal recombination. In addition to the advantages mentioned above, the parasitic absorption of the polysilicon layer is its most significant drawback. Parasitic absorption refers to an optical absorption mechanism that does not generate electron-hole pairs in the silicon body, thus reducing light utilization efficiency. To reduce recombination in the back-surface Ag metal region, the thickness of the polysilicon layer generally needs to be greater than 100nm. Reducing the thickness of the polysilicon layer without compromising the passivation of the metal region has become a primary optimization direction for TOPCon cells.

Therefore, in view of the above technical problems, it is necessary to provide a method for preparing a solar cell, a solar cell, and a photovoltaic module.

### SUMMARY

A first object of the present disclosure is to provide a method for preparing a solar cell, so as to improve the conversion efficiency and bifaciality of the cell.

A second object of the present disclosure is to provide a solar cell.

A third object of the present disclosure is to provide a photovoltaic module.

A method for preparing a solar cell according to an embodiment of a first aspect of the present disclosure includes the following steps: providing a silicon substrate, the silicon substrate including a first surface and a second surface that are disposed opposite to each other, the second surface including a first region and a second region distributed at intervals; forming a tunneling layer and a second doped layer that are stacked on the first region; preparing a second passivation layer on the second region and the second doped layer, the second passivation layer being in contact with the silicon substrate on the second region; and preparing a second electrode on the first region, the second electrode being in contact with the second doped layer.

In an embodiment, the forming the tunneling layer and the second doped layer that are stacked on the first region includes: sequentially preparing the tunneling layer, the second doped layer, and a mask on the second surface; removing the mask on the second region; and removing the second doped layer and the tunneling layer on the second region, and retaining the tunneling layer and the second doped layer on the first region.

In an embodiment, the mask on the second region is removed by a laser film patterning process; and the second doped layer and the tunneling layer on the second region are removed by a chemical etching process.

In an embodiment, the sequentially preparing the tunneling layer, the second doped layer, and the mask on the second surface includes: sequentially depositing the tunneling layer, a doped amorphous silicon layer, and the mask on the second surface of the silicon substrate; and annealing the silicon substrate deposited with the tunneling layer, the doped amorphous silicon layer, and the mask, so as to transform the doped amorphous silicon layer into a doped polysilicon layer.

In an embodiment, the method for preparing a solar cell further includes: preparing a light-trapping structure on the first surface and the second surface of the silicon substrate via a texturing process; and/or performing a polishing process on the second surface of the silicon substrate before preparing the tunneling layer, the second doped layer, and the mask.

In an embodiment, the forming the tunneling layer and the second doped layer that are stacked on the first region includes: sequentially preparing the tunneling layer and the second doped layer on the second surface; treating the second doped layer on the first region to crystallize the second doped layer on the first region, and forming an oxide layer on a surface of the second doped layer on the first region, the oxide layer serving as a mask; and removing the second doped layer and the tunneling layer on the second region, and removing the oxide layer on the first region, and retaining the tunneling layer and the second doped layer on the first region.

In an embodiment, the second doped layer on the first region is treated by a laser process, and the second doped layer and the tunneling layer on the second region, and the oxide layer on the first region are removed by a chemical etching process.

In an embodiment, the second doped layer before treated by the laser process is a doped amorphous silicon layer, and the laser process crystallizes the doped amorphous silicon layer on the first region to transform the doped amorphous silicon layer into a doped polysilicon layer, and simultaneously a silicon oxide layer is formed on the surface of the second doped layer on the first region, the silicon oxide layer serving as the mask.

In an embodiment, the chemical etching process includes: using the silicon oxide layer as the mask, removing all the doped amorphous silicon layer on the second region, and then removing the tunneling layer on the second region and the silicon oxide layer on the first region.

In an embodiment, the method for preparing a solar cell further includes: preparing a light-trapping structure on the first surface and the second surface of the silicon substrate via a texturing process; and/or performing a polishing process on the second surface of the silicon substrate before preparing the tunneling layer and the second doped layer.

A solar cell according to an embodiment of a second aspect of the present disclosure includes a silicon substrate, the silicon substrate includes a first surface and a second surface that are disposed opposite to each other, the second surface includes a first region and a second region distributed at intervals. A tunneling layer in direct contact with the silicon substrate, a second doped layer disposed on the tunneling layer, and a second electrode are provided on the first region, a second passivation layer in contact with the second surface of the silicon substrate is provided on the second region, and the second electrode is in contact with the second doped layer.

In an embodiment, the second passivation layer extends onto the first region and covers the tunneling layer and the second doped layer.

In an embodiment, the second passivation layer is an aluminum oxide passivation layer having a thickness of 2nm to 7nm, or 3nm to 6nm, or 3nm to 5nm.

In an embodiment, a second anti-reflection layer is stacked on the second passivation layer, and the second anti-reflection layer is a film formed of any one of a silicon nitride layer, a silicon oxynitride layer, and a silicon oxide layer or a stacked film formed of two or more of a silicon nitride layer, a silicon oxynitride layer, and a silicon oxide layer and has a thickness of 60nm to 130nm.

In an embodiment, a doping type of the second doped layer is the same as a doping type of the silicon substrate. The silicon substrate is an N-type silicon substrate, and the second doped layer is an N-type doped polysilicon layer; and/or the second doped layer has a surface doping concentration of 1E20cm⁻³ to 1E21cm⁻³, and a thickness of 1nm to 150nm, or 50nm to 100nm, or 80nm to 100nm.

In an embodiment, the tunneling layer is one or a combination of a silicon oxide layer and a silicon oxynitride layer, and has a thickness of 0.5nm to 3nm, or 1.5nm to 2.5nm.

In an embodiment, a first doped layer and a first electrode are formed at the first surface of the silicon substrate, a doping type of the first doped layer is opposite to the doping type of the silicon substrate, and the first electrode is in contact with the first doped layer.

In an embodiment, a first passivation layer and/or a first anti-reflection layer are stacked on the first doped layer; the first passivation layer is an aluminum oxide passivation layer having a thickness of 2nm to 7nm, or 3nm to 6nm; and/or the first anti-reflection layer is a film formed of any one of a silicon nitride layer, a silicon oxynitride layer, and a silicon oxide layer or a stacked film formed of two or more of a silicon nitride layer, a silicon oxynitride layer, and a silicon oxide layer, and has a thickness of 60nm to 130nm.

In an embodiment, the first region includes a plurality of first sub-regions that are distributed in parallel and at equal intervals, the second electrode includes a plurality of grid lines distributed in parallel, and a width of the first sub-region is greater than or equal to a width of the grid line.

A photovoltaic module according to an embodiment of a third aspect of the present disclosure includes the solar cell prepared by the method described above or the solar cell described above.

Compared with the prior art, the present disclosure has the following beneficial effects.

The present disclosure, by preparing a mask on the back surface of the silicon substrate and using a laser for patterned film opening, and then using chemical etching to remove the polysilicon layer in the non-metal region of the back surface, can improve the short-circuit current of the cell, thereby enhancing the conversion efficiency and bifaciality of the cell.

### BRIEF DESCRIPTION OF DRAWINGS

In order to more clearly illustrate technical solutions in embodiments of the present disclosure or the prior art, drawings that need to be used in the description of the embodiments or the prior art will be briefly introduced. Obviously, the drawings in the following description are only some of the embodiments recorded in the present disclosure, and for the person of ordinary skill in the field, other drawings can be obtained according to these drawings without any creative labor.
FIG. 1 is a schematic diagram showing a structure of a solar cell in embodiment 1 of the present disclosure;
FIG. 2 is a schematic diagram showing a partial structure at A in FIG. 1;
FIG. 3 is a schematic planar diagram of a second surface of a silicon substrate in embodiment 1 of the present disclosure;
FIG. 4 is a schematic planar diagram of the second surface and a second electrode in embodiment 1 of the present disclosure;
FIGS. 5a to 5j are flow charts of a preparation process of the solar cell in embodiment 1 of the present disclosure;
FIG. 6 is a schematic diagram of a laser pattern in a laser film patterning process in embodiment 1 of the present disclosure;
FIG. 7 is a surface topography diagram of the second region on the silicon substrate after a chemical etching process in embodiment 1 of the present disclosure;
FIGS. 8a to 8c are flow charts of a preparation process for preparing a first doped layer at a first surface of a silicon substrate in embodiment 2 of the present disclosure;
FIGS. 9a to 9j show another flow chart of a preparation process of the solar cell in embodiment 3 of the present disclosure;
FIG. 10 is a schematic diagram of a laser scanning pattern in a laser process in embodiment 3 of the present disclosure;
FIG. 11 is a schematic diagram showing a structure of a solar cell in embodiment 5 of the present disclosure;
FIG. 12 is a schematic diagram showing a partial structure at B in FIG. 11.

Description of main reference numbers:
silicon substrate 10; first doped layer 11; boron-doped amorphous silicon layer 11'; first passivation layer 21; first anti-reflection layer 31; tunneling layer 12; second doped layer 13; oxide layer 131; second passivation layer 22; second anti-reflection layer 32; first electrode 41; second electrode 42; sub-grid line 421; mask 50; first surface S1; second surface S2; first region S21; second region S22; first sub-region 101; second sub-region 102.

### DESCRIPTION OF EMBODIMENTS

In order to better understand the technical solutions in the present disclosure for the person skilled in the field, the technical solutions in the embodiments of the present disclosure will be clearly and completely described below with reference to the drawings in the embodiments of the present disclosure. Obviously, the described embodiments are only a part of the embodiments of the present disclosure, and not all of the embodiments. Based on the embodiments in the present disclosure, all other embodiments obtained by the person of ordinary skills in the field without making any creative labor should fall within the protection scope of the present disclosure.

In the present disclosure, unless otherwise clearly specified and defined, a first feature being "above" or "below" a second feature may refer to a direct contact between the first feature and the second feature, or an indirect contact between the first feature and the second feature through an intermediate medium. Furthermore, the first feature being "on top of", "above" and "on" the second feature may refer to the first feature being directly above or diagonally above the second feature, or may simply refer to the first feature being at a horizontal height higher than that of the second feature. The first feature being "below", "under" and "underneath" the second feature may refer to the first feature being directly below or diagonally below the second feature, or may simply refer to the first feature being at a horizontal height less than that of the second feature.

A first aspect of the present disclosure provides a method of preparing a solar cell. The method includes the flowing steps of:
providing a silicon substrate, the silicon substrate including a first surface and a second surface that are disposed opposite to each other, the second surface including a first region and a second region distributed at intervals;
forming a tunneling layer and a second doped layer that are stacked on the first region;
preparing a second passivation layer on the second region and the second doped layer, the second passivation layer being in contact with the silicon substrate on the second region; and
preparing a second electrode on the first region, the second electrode being in contact with the second doped layer.

In one embodiment, the forming the tunneling layer and the second doped layer that are stacked on the first region includes: sequentially preparing the tunneling layer, the second doped layer, and a mask on the second surface; removing the mask on the second region; and removing the second doped layer and the tunneling layer on the second region, and retaining the tunneling layer and the second doped layer on the first region.

In one embodiment, the mask on the second region is removed by a laser film patterning process; and the second doped layer and the tunneling layer on the second region are removed by a chemical etching process.

In one embodiment, the sequentially preparing the tunneling layer, the second doped layer, and the mask on the second surface includes: sequentially depositing the tunneling layer, a doped amorphous silicon layer, and the mask on the second surface of the silicon substrate; and annealing the silicon substrate deposited with the tunneling layer, the doped amorphous silicon layer and the mask, so as to transform the doped amorphous silicon layer into a doped polysilicon layer.

In one embodiment, the method for preparing a solar cell further includes: preparing a light-trapping structure on the first surface and the second surface of the silicon substrate via a texturing process; and/or performing a polishing process on the second surface of the silicon substrate before preparing the tunneling layer, the second doped layer, and the mask.

In one embodiment, the forming the tunneling layer and the second doped layer that are stacked on the first region includes: sequentially preparing the tunneling layer and the second doped layer on the second surface; treating the second doped layer on the first region to crystallize the second doped layer on the first region, and forming an oxide layer on a surface of the second doped layer on the first region, the oxide layer serving as a mask; and removing the second doped layer and the tunneling layer on the second region, and removing the oxide layer on the first region, and retaining the tunneling layer and the second doped layer on the first region.

In one embodiment, the second doped layer on the first region is treated by a laser process, and the second doped layer and the tunneling layer on the second region, and the oxide layer on the first region are removed by a chemical etching process.

In one embodiment, the second doped layer before treated by the laser process is a doped amorphous silicon layer, and the laser process crystallizes the doped amorphous silicon layer on the first region to transform the doped amorphous silicon layer into a doped polysilicon layer, and simultaneously a silicon oxide layer is formed on the surface of the second doped layer on the first region, the silicon oxide layer serving as the mask.

In one embodiment, the chemical etching process includes: using the silicon oxide layer as the mask, removing all the doped amorphous silicon layer on the second region, and then removing the tunneling layer on the second region and the silicon oxide layer on the first region.

In one embodiment, the method for preparing a solar cell further includes: preparing a light-trapping structure on the first surface and the second surface of the silicon substrate via a texturing process; and/or performing a polishing process on the second surface of the silicon substrate before preparing the tunneling layer and the second doped layer.

Specifically, a method for preparing a solar cell includes:
providing a silicon substrate, the silicon substrate including a first surface and a second surface that are disposed opposite to each other, the second surface including a first region and a second region;
preparing a tunneling layer, a second doped layer, and a mask that are sequentially stacked on the second surface;
removing the mask on the second region by a laser film patterning process;
removing the second doped layer on the second region by a chemical etching process, and retaining the tunneling layer and the second doped layer on the first region;
preparing a second electrode on the first region, the second electrode being in contact with the second doped layer.

Furthermore, this method for preparing a solar cell further includes:
forming a first doped layer on the first surface, the doping type of the first doped layer being opposite to that of the second doped layer; and
preparing a first electrode on the first surface, the first electrode being in contact with the first doped layer.

Thus, the present disclosure, by preparing a mask on the back surface of the silicon substrate, using a laser for patterned film opening, and then using chemical etching to remove the polysilicon layer on the non-metal region of the back surface, can improve the short-circuit current of the cell, thereby enhancing the conversion efficiency and bifaciality of the cell.

Another method for preparing a solar cell includes:
providing a silicon substrate, the silicon substrate including a first surface and a second surface that are disposed opposite to each other, the second surface including a first region and a second region;
preparing a tunneling layer and a second doped layer that are sequentially stacked on the second surface;
treating the second doped layer on the first region using a laser process, so as to crystallize the second doped layer on the first region and form an oxide layer on a surface of the second doped layer on the first region;
removing at least a part of the second doped layer on the second region and the oxide layer on the first region using a chemical etching process, and retaining the tunneling layer and the second doped layer on the first region; and
preparing a second electrode on the first region, the second electrode being in contact with the second doped layer.

Furthermore, this preparing method further includes:
preparing a first doped layer on the first surface, the doping type of the first doped layer being opposite to that of the silicon substrate; and
preparing a first electrode on the first surface, the first electrode being in contact with the first doped layer.

Thus, in the present disclosure, by oxidizing the back-side metal region using a laser process to form an oxide layer, utilizing the instantaneous high temperature of the laser to crystallize the doped layer, and then using a chemical etching process with the oxide layer as a mask to remove the doped layer in the back-side non-metal region, both the passivation effect and the reduction of parasitic absorption can be achieved, thereby significantly improving cell efficiency and bifaciality while increasing the process window.

A second aspect of the present disclosure provides a solar cell, including a silicon substrate. The silicon substrate includes a first surface and a second surface that are disposed opposite to each other, the second surface includes a first region and a second region distributed at intervals. A tunneling layer in direct contact with the silicon substrate, a second doped layer disposed on the tunneling layer, and a second electrode are provided on the first region, a second passivation layer in contact with the second surface of the silicon substrate is provided on the second region.

A third aspect of the present disclosure provides a photovoltaic module including the solar cell prepared according to the method for preparing a solar cell in any embodiment of the first aspect described above or the solar cell according to any embodiment of the second aspect described above.

In this disclosure, the non-metallic region on the back surface of the solar cell is not protected by the tunneling layer and the second doped layer, but the second passivation layer ensures the passivation performance of the back surface of the cell. In addition, the second passivation layer has a certain blocking effect on the back-side paste, preventing the paste from burning through the second doped layer, thereby allowing the second doped layer to be further thinned. This improves the short-circuit current density of the cell without affecting the metallization contact performance, significantly enhancing cell efficiency and bifaciality.

The present disclosure is further described below in connection with specific examples.

### Embodiment 1:

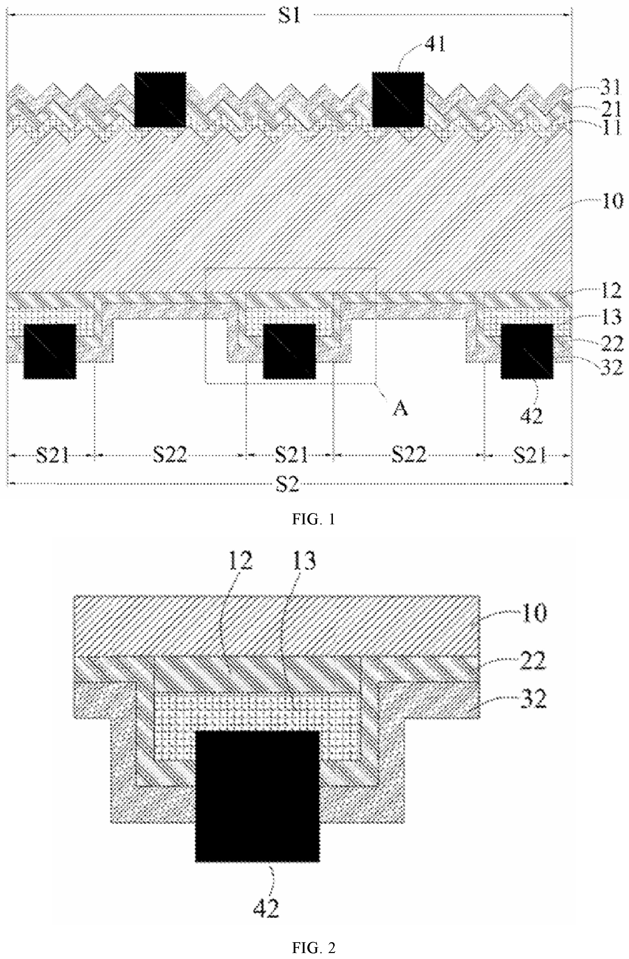

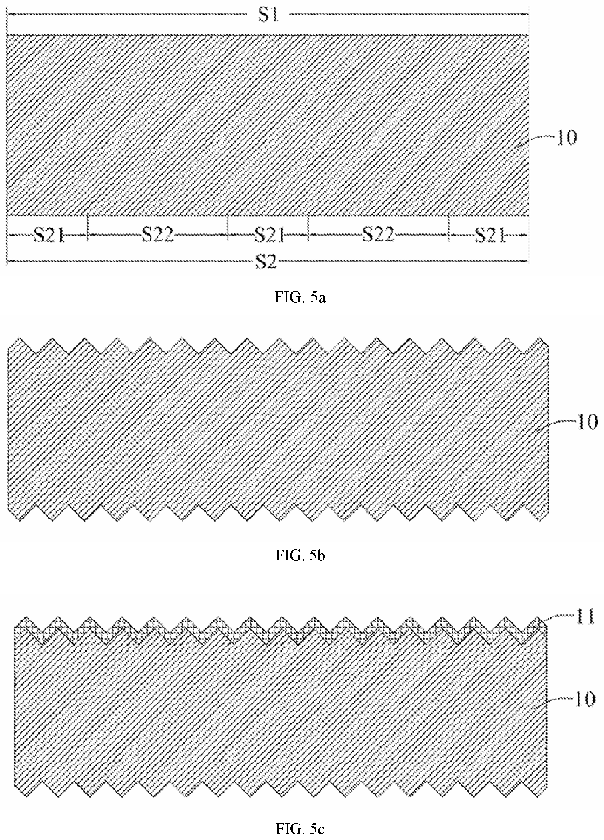

FIG. 1 is a schematic diagram showing a structure of a solar cell in this embodiment. The solar cell is a TOPCon cell and includes a silicon substrate 10. As shown in FIG. 5a, the silicon substrate 10 includes a first surface S1 and a second surface S2 that are disposed opposite to each other. The second surface S2 includes a first region S21 and a second region S22, the first surface S1 is a front surface (i.e., a light-receiving surface) of the silicon substrate 10, the second surface S2 is the back surface (i.e., a backlighting surface) of the silicon substrate 10, the first region S21 is a metal region of the back surface, and the second region S22 is a non-metal region of the back surface.

The silicon substrate 10 in this embodiment is an N-type silicon substrate with an electrical resistivity of 0.3Ω•cm to 7Ω•cm, preferably 0.5Ω•cm to 3.5Ω•cm.

Further, a light-trapping structure is formed on the first surface S1 of the silicon substrate 10. For example, a pyramid-textured structure can be formed on the first surface S1 of the silicon substrate 10 by alkali texturing, with a pyramid size of 0.5µm to 3µm. The second surface S2 of the silicon substrate 10 is a polished surface. This polished surface can be a surface obtained by chemically polishing a light-trapping structure, or can be a surface obtained by directly chemically polishing the original back surface of the silicon substrate. For instance, in this embodiment, a pyramid-textured structure is first formed on the second surface S2 of the silicon substrate 10 by alkali texturing, with a pyramid size of 0.5µm to 3µm, and then the back surface is subjected to alkali polishing to obtain the polished surface. Compared with a conventional back surface of a silicon substrate, multiple pyramid bases (the pyramid base is a base left after polishing the pyramid-textured structure) can be formed on the polished surface.

In this embodiment, a first doped layer 11 is formed at the first surface S1 of the silicon substrate 10 by a diffusion process, thereby forming a PN junction which generates minority carrier-hole pairs after illumination. Illustratively, the first doped layer 11 is a P-type doped layer (i.e., P+ emitter) formed by a boron doping process. For example, it is formed below the first surface S1 of the silicon substrate (i.e., inside the silicon substrate) by the boron doping process, having a surface doping concentration of 3E18cm⁻³ to 3E19cm⁻³, and a sheet resistance of 250 Ω/sq to 300 Ω/sq, preferably 250 Ω/sq to 280 Ω/sq.

As shown in FIG. 1 and in conjunction with FIG. 2, in this embodiment, a tunneling layer 12 and a second doped layer 13 are provided only on the first region S21 of the second surface S2 of the silicon substrate 10, while the second region S22 does not have a tunneling layer and a second doped layer. That is, the tunneling layer 12 in direct contact with the silicon substrate 10 and the second doped layer 13 disposed on the tunneling layer 12 are formed only on the first region S21.

In conjunction with FIG. 2, in this embodiment, a tunneling layer 12 and a second doped layer 13 are sequentially stacked on the first region S21 on the second surface S2 of the silicon substrate 10. For example, projections of the tunneling layer 12 and the second doped layer 13 on the second surface S2 of the silicon substrate 10 are located within the first region S21. The tunneling layer 12 on the first region S21 is in direct contact with the second surface S2 of the silicon substrate 10, and can provide a good interface passivation effect on the first region S21. The second doped layer 13 can provide a field passivation effect, and because this layer has a relatively high doping concentration, it can improve contact and reduce resistance.

Specifically, the tunneling layer 12 is any one of a silicon oxide layer and a silicon oxynitride layer or a combination thereof. The tunneling layer 12 is preferably a silicon oxide layer. The tunneling layer 12 has a thickness of 0.5nm to 3nm, preferably 1nm to 3nm, and more preferably 1.5nm to 2.5nm. The second doped layer 13 is a phosphorus-doped N-type doped polysilicon layer, and has a surface doping concentration of 1E20cm⁻³ to 1E21cm⁻³, preferably 2E20cm⁻³ to 3E21cm⁻³, and more preferably 5E20cm⁻³ to 2E21cm⁻³. The tunneling layer 12 has a thickness of 1nm to 120nm, preferably 1nm to 150nm, more preferably 50nm to 100nm, and even more preferably 80nm to 100nm. The thickness of the second doped layer 13 in this embodiment is further reduced, which can reduce parasitic absorption without affecting the metallization contact performance, thereby improving the short-circuit current density of the cell and significantly enhancing efficiency and bifaciality of the cell.

Preferably, in this embodiment, a first passivation layer 21 and a first anti-reflection layer 31 are sequentially stacked on the first surface S1 of the silicon substrate 10, and a second passivation layer 22 and a second anti-reflection layer 32 are sequentially stacked on the second surface S2 of the silicon substrate 10. The second passivation layer 22 and the second anti-reflection layer 32 cover the second doped layer 13 and extend into the second region S22. Within the second region S22, the second passivation layer 22 is in direct contact with the silicon substrate 10. The first passivation layer 21 can provide excellent field passivation and chemical passivation effects, the second passivation layer 22 can provide a chemical passivation effect, and the first anti-reflection layer 31 can reduce reflectivity and increase light utilization.

Exemplarily, the first passivation layer 21 is an aluminum oxide passivation layer with a thickness of 2nm to 7nm, preferably 3nm to 6nm. The second passivation layer 22 is an aluminum oxide passivation layer with a thickness of 3nm to 5nm. Each of the first anti-reflection layer 31 and the second anti-reflection layer 32 can be any one of a silicon nitride layer, a silicon oxynitride layer and a silicon oxide layer, or a stacked film formed of two or more of a silicon nitride layer, a silicon oxynitride layer, and a silicon oxide layer. Each of the first anti-reflection layer 31 and the second anti-reflection layer 32 has a thickness of 60nm to 130nm, and is preferably a silicon nitride layer. Silicon nitride has inactive chemical properties and has strong resistance to acid and alkali corrosion, which can reduce the sensitivity of the cell to the environment.

In addition, in this embodiment, a first electrode 41 is disposed on the first surface S1 of the silicon substrate 10 and directly contacts with the first doped layer 11; and a second electrode 42 is disposed on the second surface S2 of the silicon substrate 10, specifically in the first region S21 of the second surface S2, and directly contacts with the second doped layer 13.

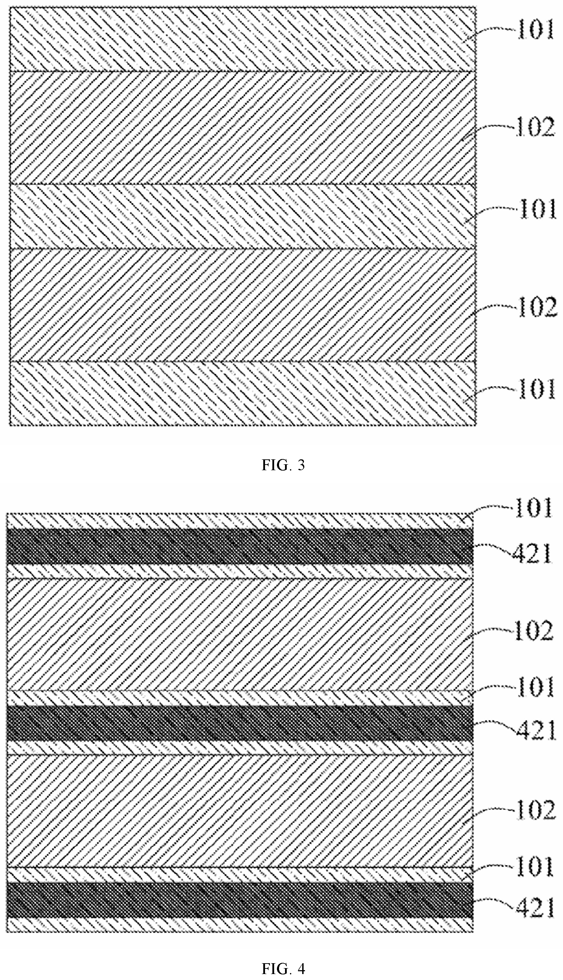

Referring to FIG. 3, the first region S21 in this embodiment includes a plurality of first sub-regions 101 that are distributed in parallel and at equal intervals, the second region S22 includes a plurality of second sub-regions 102 that are distributed in parallel and at equal intervals, and the first sub-region 101 and the second sub-region 102 are alternately distributed. The first sub-region 101 has a width smaller than a width of the second sub-region 102. For example, a ratio of the widths of the first and second sub-regions 101 and 102 may be 1:(5~20). Preferably, an area of the first region S21 accounts for about 10% of an area of the entire second surface S2.

As shown in FIG. 4, the second electrode 42 is a grid line electrode that includes at least a plurality of sub-grid lines 421 distributed in parallel, and the first sub-region 101 has a width greater than or equal to a width of the sub-grid line 421. Optionally, the second electrode 42 may further include a plurality of main grid lines (not shown) distributed perpendicular to the sub-grid lines 421.

In this embodiment, a 210 TOPCon cell is taken as an example. The cell has a size of 203.396±15mm, and the number of the sub-grid lines 421 is 230, the sub-grid line 421 has a width of 15µm to 100µm, and a spacing between adjacent sub-grid lines 421 is 0.907±0.015mm. The spacing between adjacent first sub-regions 101 is equal to the spacing between the adjacent sub-grid lines 421, and there is one sub-grid line 421 distributed in each first sub-region 101. The first sub-region 101 has a width greater than the width of the sub-grid line 421. The first sub-region has a width of 50µm to 150µm. For example, a width of the fine grid line is 40µm, and a width of the first sub-region is 80µm.

In this embodiment, the tunneling layer and the doped polysilicon layer on the first region S21 can ensure a passivation effect, while the second passivation layer prepared on the second region S22 can ensure a good passivation effect on the second region S22. Moreover, the second passivation layer 22 has a certain blocking effect on the back-side paste, so the thickness of the second doped layer 13 can be further reduced, thereby increasing the short-circuit current density of the cell.

It should be understood that the second passivation layer 22 in this embodiment covers the entire second surface S2 of the silicon substrate 10, that is, is directly stacked on the silicon substrate surface in the second region S22 and also stacked on the second doped layer 13 in the first region S21. In other embodiments, the second passivation layers 22 on the first region S21 and the second region S22 could be passivation layers of different materials, i.e., passivation layers could be deposited separately on the first region S21 and the second region S22, respectively. Furthermore, since the first region S21 has the tunneling layer 12 in direct contact with the silicon substrate 10 and the second doped layer 13 disposed on the tunneling layer 12, the second passivation layer 22 could be stacked only on the second region S22.

The method for preparing the solar cell in this embodiment specifically includes the following steps.

### 1. Double-side texturing

Referring to FIG. 5a, a silicon substrate 10 is provided. The silicon substrate 10 includes a first surface S1 and a second surface S2 that are disposed opposite to each other. The second surface S2 includes a first region S21 and a second region S22. The first surface S1 is a front surface (i.e., a light-receiving surface) of the silicon substrate 10, and the second surface S2 is a back surface (i.e., a backlighting surface) of the silicon substrate 10. The first region S21 is a metal region of the back surface, the second region S22 is a non-metal region of the back surface.

The silicon substrate 10 in this embodiment is an N-type silicon substrate with an electrical resistivity of 0.3Ω•cm to 7Ω•cm, preferably 0.5Ω•cm to 3.5Ω•cm. Referring to FIG. 5b, the first surface S1 and the second surface S2 of the silicon substrate 10 are formed with a pyramid-textured structure through an alkali texturing process (not shown), and the pyramid has a size of 0.5µm to 3µm.

### 2. Boron diffusion

Referring to FIG. 5c, a first doped layer (i.e., a P+emitter) 11, which is P-type doped, is formed on the first surface S1 of the silicon substrate 10 by a boron diffusion process. For example, diffusion is performed in a high-temperature furnace tube using a boron source (such as BCl₃ or BBr₃) deposition and propulsion method, and a layer of silicon oxide is formed on the outer surface. The first doped layer 11 obtained after this diffusion has a doping concentration of 3E18cm⁻³ to 3E19cm⁻³, and has a square resistance of 250Ω/sq to 300Ω/sq, preferably 250Ω/sq to 280Ω/sq. In the boron diffusion process, a Boron-Silicate Glass (BSG, not shown) is formed on the second surface S2 of the silicon substrate 10.

For example, in this embodiment, the outer silicon layer of the first surface S1 of the silicon substrate 10 is transformed into a boron diffusion layer. In FIG. 5c, the total thickness of the silicon substrate 10 and the first doped layer 11 after boron diffusion is equal to the thickness of the silicon substrate 10 before boron diffusion in FIG. 5b.

### 3. Back surface polishing

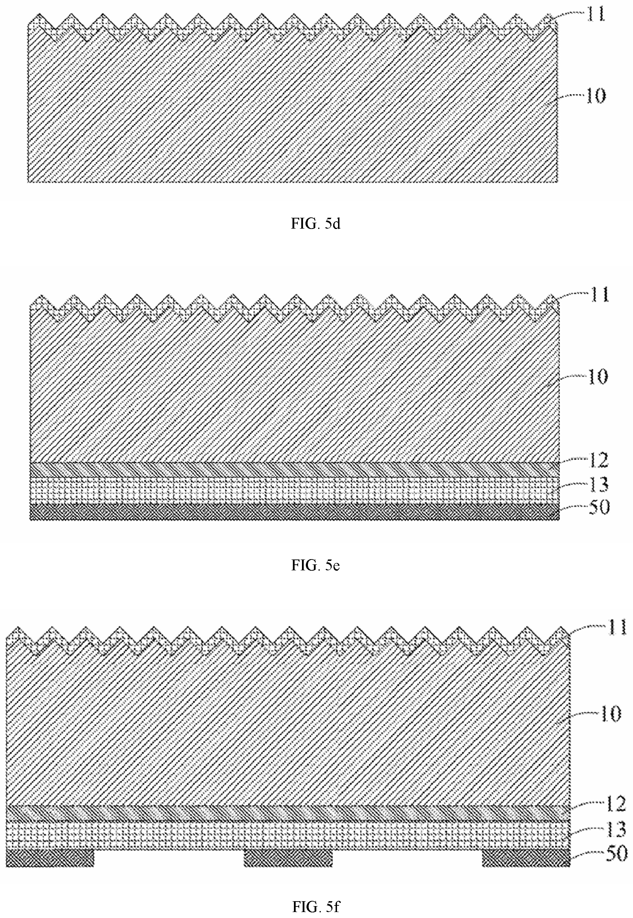

Referring to FIG. 5d, the silicon substrate 10 obtained after boron diffusion firstly passes through a single-sided chain device to remove the silicon oxide on the back surface using a hydrofluoric acid solution, and then the back surface is subject to alkali polishing to remove edge knots and a back surface wraparound (BSG), and finally cleaning is performed.

### 4. Preparation of tunneling and passivation structure on the back surface

As shown in FIG. 5e, a tunneling layer 12, a second doped layer 13, and a mask 50 stacked in sequence are prepared on the second surface S2.

As an example, in this embodiment, a silicon oxide layer as a tunneling layer is firstly deposited on the back surface using a Plasma Enhanced Chemical Vapor Deposition (PECVD) process. The silicon oxide layer has a thickness of 1nm to 3nm. Then, a layer of phosphorus-doped amorphous silicon or multiple layers of phosphorus-doped amorphous silicon with different doping concentrations is/are deposited, with a total thickness of 1nm to 120nm, preferably 80nm to 100nm. Finally, a silicon oxide mask layer is deposited, with a mask thickness of 2nm to 50nm, preferably 15nm to 20nm.

### 5. Annealing Activation

Annealing treatment is performed in a high-temperature annealing furnace at a temperature of 880°C to 980°C, preferably 900°C to 950°C. After annealing, the phosphorus-doped amorphous silicon layer transforms into a phosphorus-doped polysilicon silicon layer. Phosphorus activation is achieved through annealing, forming the tunneling layer 12 and the second doped layer 13 on the back surface.

### 6. Mask patterning using laser

As shown in FIG.5f, the mask 50 on the second region S22 is removed by a laser film patterning process.

After annealing, the structure on the back surface of the silicon substrate 10 is: Tunneling layer (SiOz) + Doped polysilicon layer (N+poly) + Mask (SiOz). The laser processing mainly acts on the mask (SiOz) 50. For a silicon oxide mask with a thickness of 15nm to 20nm, the laser power in the laser film patterning process is 45W to 55W, preferably 50W; the scanning speed is 40000 mm/s to 60000 mm/s, preferably 50000 mm/s; and the laser frequency is 500 kHz to 600 kHz, preferably 500 kHz.

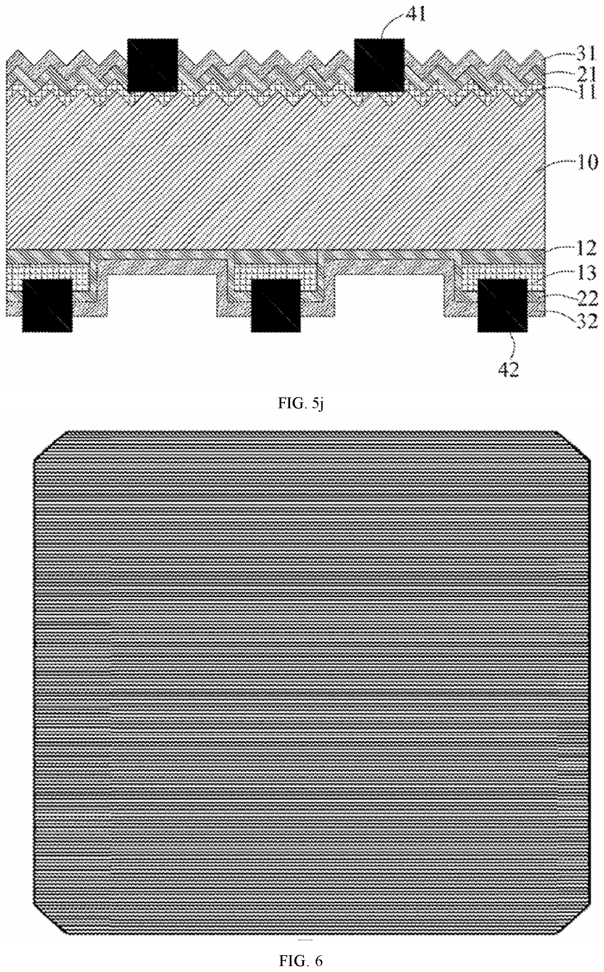

FIG.6 shows the laser pattern in the laser film patterning process of this embodiment. The black line portions correspond to the metal regions, i.e., the first regions S21, and the blank portions are the laser scanning regions, i.e., the second regions S22. Referring further to FIG.3, the laser scanning region is the second region S22 (i.e., back-side non-metal region). The laser film pattering process removes the mask 50 on the second region S22, exposing the underlying doped polysilicon layer.

It should be understood that the laser pattern in the present disclosure can be designed according to different electrode structures, so as to remove the mask in the laser scanning region (i.e., back-side non-metal region) while retaining the mask at the back-side metal region. Laser patterns for other electrode structures are not exhaustively illustrated here.

### 7. Removing wraparound and chemical etching

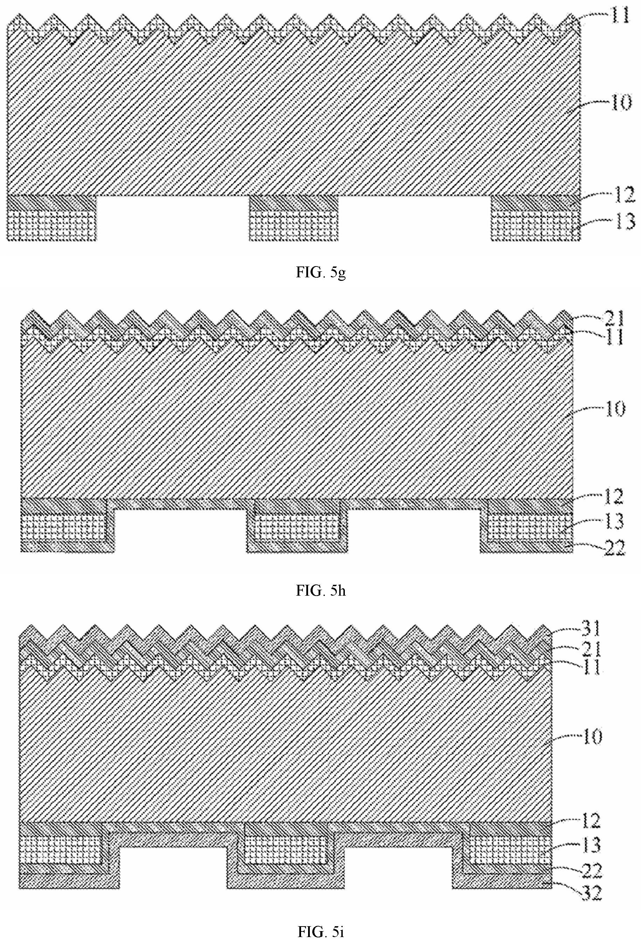

As shown in FIG. 5g, this step specifically includes the following operations. Acid pickling 1: for example, the mask 50 wrapped around the edge of the silicon substrate 10 is removed using an acid solution in an acid pickling tank. The acid solution has a mass fraction of 5% to 30%, and the treatment time duration is 30s to 100s, preferably 60s. Illustratively, in this step, the front side of the silicon substrate 10 passes through a chain-type hydrofluoric acid tank to remove the silicon oxide mask wrapped around the edge on a single side.

Alkali etching: for example, the second doped layer 13 on the second region S22 is removed using an alkali solution in an alkali pickling tank. The alkali solution has a mass fraction of 3% to 15%, and the treatment time duration is 100s to 500s, preferably 350s.

Acid pickling 2: for example, the tunneling layer 12 on the second region S22 and the mask 50 on the first region S21 are removed using an acid solution in an acid pickling tank. The acid solution has a mass fraction of 5% to 20%, and the treatment time duration is 100s to 500s, preferably 300s.

Finally, RCA cleaning is performed. RCA cleaning is a conventional technique and is not described in detail here.

Preferably, the acid solution in this embodiment is obtained by mixing industrial-grade hydrofluoric acid solution (the mass fraction is 40%) with water in a certain ratio. The alkali solution is obtained by mixing industrial-grade sodium hydroxide solution (the mass fraction is 32%) with water in a certain ratio.

After the laser film pattering process, the mask 50 on the second region S22 has been removed by the laser. In the alkali etching step, the doped polysilicon in the second region S22 is etched by the alkali solution. After 350s, the doped polysilicon in the second region S22 is completely etched away, while the first region S21 are protected by the mask, so the doped polysilicon on the first region S21 remains unaffected.

During the alkali etching process, the second doped layer 13 (i.e., phosphorus-doped polysilicon layer) on the second region S22 is corroded away, which can reduce parasitic absorption on the back surface of the cell and significantly increase the current. The first region S21 is protected by the mask 50, preventing corrosion by the alkali solution, thereby ensuring that the contact performance between the back electrode and the second doped layer remains unaffected.

It should be noted that during the acid pickling process to remove the tunneling layer 12 on the second region S22 and the mask 50 on the first region S21, the silicon substrate 10 in the second region S22 is also slightly etched away. Therefore, the silicon substrate 10 in the second region S22 is slightly thinner than the silicon substrate 10 in the first region S21. In other words, after this acid pickling step, the silicon substrate 10 in the second region S22 is recessed towards the first surface S1 compared to the silicon substrate 10 in the first region S21.

### 8. Preparing a passivation layer

Referring to FIG. 5h, an ALD (Atomic Layer Deposition) process is used to prepare a first passivation layer 21 and a second passivation layer 22 on the first surface S1 and the second surface S2 of the silicon substrate, respectively. The first passivation layer 21 is an aluminum oxide passivation layer with a thickness of 2nm to 7nm, preferably 3nm to 6nm. The second passivation layer 22 is an aluminum oxide passivation layer with a thickness of 3nm to 5nm.

After the steps of removing wraparound and chemical etching, the tunneling layer and the doped polysilicon layer on the first region S21 can still ensure passivation performance. However, the second region S22 lacks the protection of a passivation layer. Therefore, while preparing the first passivation layer on the front side, it is necessary to simultaneously prepare the second passivation layer on the back side, thereby ensuring good interface passivation performance on the second region S22.

Furthermore, under the high-temperature sintering conditions that ensure good front-side contact, the second passivation layer 22 has a certain blocking effect on the back-side paste. Therefore, the second doped layer 13 can be further thinned, thereby increasing the short-circuit current density of the cell.

### 9. Preparing a anti-reflection layer

Referring to FIG. 5i, a PECVD process is used to prepare a first anti-reflection layer 31 and a second anti-reflection layer 32 on the first surface S1 and the second surface S2 of the silicon substrate, respectively. Each of the first anti-reflection layer 31 and the second anti-reflection layer 32 can be a film formed of any one of a silicon nitride layer, a silicon oxynitride layer, and a silicon oxide layer or a stacked film formed of two or more of a silicon nitride layer, a silicon oxynitride layer, and a silicon oxide layer, and has a thickness of 60nm to 130nm.

### 10. Printing metal electrode

Referring to FIG. 5j, a first electrode 41 and a second electrode 42 are printed, by a screen-printing process, on the front surface and the back surface respectively, and then sintering and optical or electric injection are performed to form an ohmic contact.

The first electrode 41 and the second electrode 42 are grid line electrodes in the prior art, and each typically includes a main grid line and a sub-grid line. It is worth noting that since the sub-grid line 421 in the second electrode 42 needs to be printed on the first region S21, the width of the first sub-region 101 needs to be larger than the width of the sub-grid line 421 in the second electrode 42, so that correct orientation of the sub-grid line 421 can be realized.

The process flow in this embodiment is: texturing → boron diffusion → back-side polishing → PE-poly → annealing → laser film patterning → removing wraparound → ALD → PECVD → screen printing. A TOPCon cell can be prepared through the above steps, and finally the cell is tested, sorted and put in storage.

### Comparative Example 1:

The process flow in this comparative example is: texturing → boron diffusion → back-side polishing → PE-poly → annealing → removing wraparound → ALD → PECVD → screen printing. This process flow represents a mass production process used in the prior art.

Compared with embodiment 1, in this comparative example, a mask is not deposited during the back-side tunneling passivation structure preparation step, and a laser film patterning process is not performed. The entire back surface of the silicon substrate is covered with a tunneling layer and a doped polysilicon layer. All other aspects are identical to those of Example 1.

### Comparative Example 2:

The process flow in this comparative example is: texturing → boron diffusion → back-side polishing → LP-poly + phosphorus diffusion → annealing → laser → removing wraparound → ALD → PECVD → screen printing.

Compared with embodiment 1, in this comparative example, a laser is used to remove, in one single step, the PSG (phosphosilicate glass), polysilicon (poly), and SiO₂ tunneling layer formed after LP-poly + phosphorus diffusion (~870°C) in the non-metal region, followed by chemical etching of the remaining polysilicon.

Compared with comparative example 1, embodiment 1 only requires the addition of one laser film patterning step, making the preparation method simple. Testing the TOPCon cells prepared according to embodiment 1 and comparative example 1 obtains the performance parameters shown in Table 1.

**Table 1: Comparison of TOPCon Cell Performance Parameters**

| Group | Poly Thickness | Eta (%) | Isc (A) | Uoc (mV) | FF (%) | Rs (mΩ) | Rsh (mΩ) | Quantity | Bifaciality |
|---|---|---|---|---|---|---|---|---|---|
| Comparative Example 1 | 120nm | 24.69 | 17.97 | 729.1 | 83.10 | 0.84 | 714 | 2474 | 82% |
| Embodiment 1 | 120nm | 25.10 | 18.16 | 734.2 | 83.00 | 0.90 | 856 | 2636 | 88% |

It can be seen that the cell performance of embodiment 1 is significantly improved compared to comparative example 1. The short-circuit current Isc can be increased by about 1%, the cell conversion efficiency Eta can be increased by about 0.4%, the back-side parasitic absorption can be greatly reduced, and the bifaciality can be increased by up to about 6%.

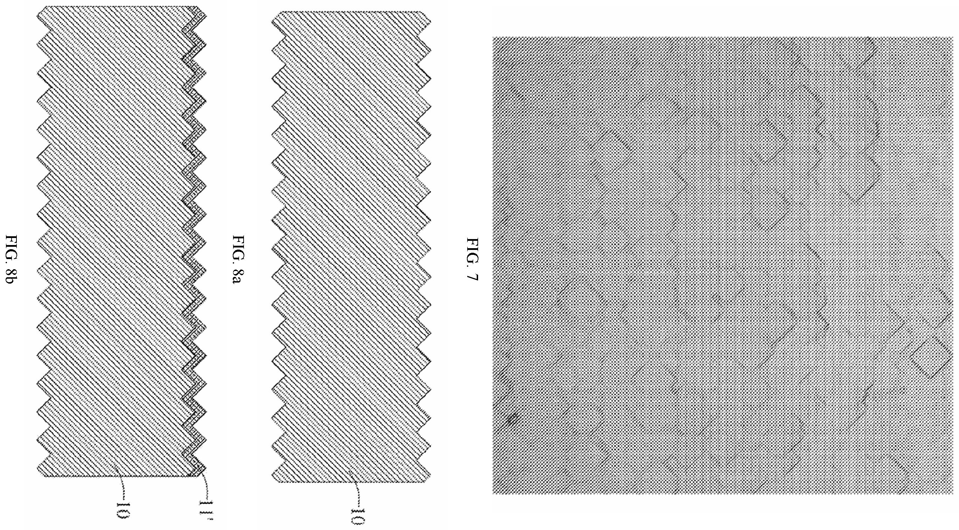

Compared with comparative example 2, embodiment 1 uses a laser to pattern the silicon oxide mask and then removes the polysilicon and tunneling silicon oxide through a chemical etching process. In contrast, comparative example 2 uses a laser to remove the PSG, polysilicon, and tunneling silicon oxide in one step. Embodiment 1 has at least the following advantages.
1. Regarding adjusting the laser parameters by the silicon oxide mask, the laser film patterning process is used to only remove the silicon oxide mask in the non-metal region, without affecting the passivation performance of the back-side metal region.
2. Compared to PSG, the silicon oxide mask has a higher crystallization temperature and better density, making it more effective at preventing laser damage to the amorphous silicon layer on the silicon substrate.
3. Using a chemical etching process to remove the polysilicon and tunneling silicon oxide is gentler and causes less damage compared to laser removal process. At the same time, the chemical etching process forms pyramid bases (i.e., the bases remaining after polishing the pyramid textured structure) in the non-metal region as shown in FIG. 7. This pyramid base structure can further enhance photoelectric conversion efficiency and increase the bifaciality.

### Embodiment 2:

The solar cell and the method for preparing the solar cell in this embodiment are substantially the same as those in Embodiment 1, except that the first doped layer 11 in embodiment 1 is prepared by a boron diffusion process, whereas in this embodiment, the first doped layer 11 is prepared by a PECVD process.

Specifically, in this embodiment, a PECVD process is first used to deposit a boron-doped amorphous silicon layer 11' on the first surface S1, and then the high-temperature oxidation annealing is performed to form the first doped layer 11, i.e., a P-type doped polysilicon layer.

As shown in FIG. 8a, double-sided texturing is first performed on the silicon substrate 10. The texturing process is identical to that in embodiment 1 and will not be repeated here.

As shown in FIG. 8b, a PECVD process is used to first deposit a boron-doped amorphous silicon layer 11' on the first surface S1. Exemplarily, in the PECVD process, N₂O is first introduced to form a silicon oxide layer (not shown) on the first surface S1. Then, SiH₄ and trimethyl-boron are introduced to form a boron-doped amorphous silicon layer on the silicon oxide layer. Finally, N₂O is introduced to form a silicon oxynitride mask (not shown).

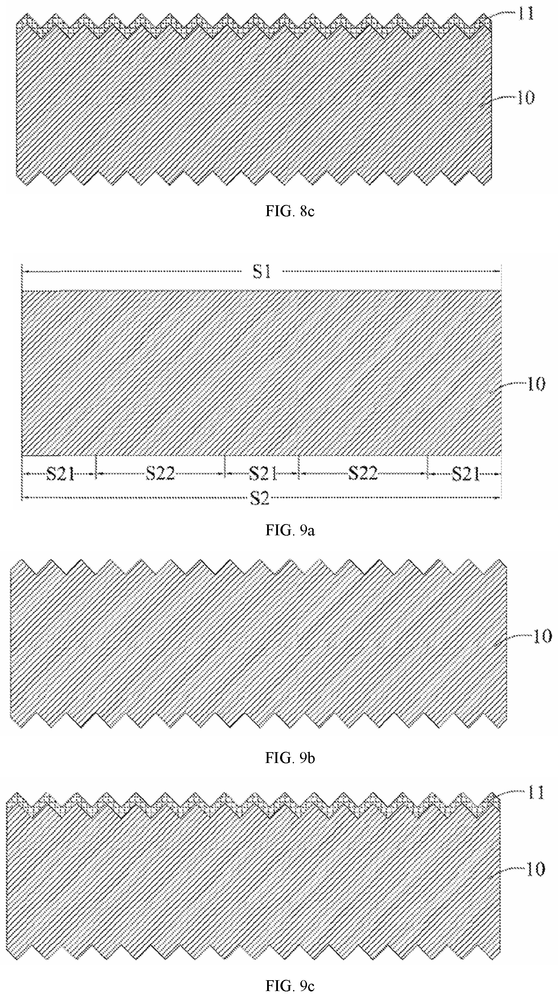

As shown in FIG. 8c, the first doped layer 11 is finally formed through a high-temperature oxidation annealing process. The high-temperature oxidation annealing process can transform the P-type doped amorphous silicon layer into a P-type doped polysilicon layer.

Unlike Embodiment 1, in this embodiment, a PECVD process and an annealing method are used to prepare a P-type doped polysilicon layer on the surface of the silicon substrate 10. During this process, the thickness of the silicon substrate 10 remains constant. In FIG. 8c, the total thickness of the silicon substrate 10 and the first doped layer 11 after annealing is equal to the total thickness of the silicon substrate 10 and the boron-doped amorphous silicon layer 11' before annealing in FIG. 8b, and is greater than the thickness of the silicon substrate 10 before the PECVD process in FIG. 8a.

### Embodiment 3:

The structure of the solar cell in this embodiment is identical to that of Embodiment 1, but the method for preparing the solar cell is different. The method for preparing the solar cell in this embodiment specifically includes the following steps:

### 1. Double-side texturing

Referring to FIG. 9a, a silicon substrate 10 is provided. The silicon substrate 10 includes a first surface S1 and a second surface S2 that are disposed opposite to each other. The second surface S2 includes a first region S21 and a second region S22. The first surface S1 is a front surface (i.e., a light-receiving surface) of the silicon substrate 10, and the second surface S2 is a back surface (i.e., a backlighting surface) of the silicon substrate 10. The first region S21 is a metal region of the back surface, the second region S22 is a non-metal region of the back surface.

The silicon substrate 10 in this embodiment is an N-type silicon substrate with an electrical resistivity of 0.3Ω•cm to 7Ω•cm, preferably 0.5Ω•cm to 3.5Ω•cm.

Referring to FIG. 9b, the first surface S1 and the second surface S2 of the silicon substrate 10 in this embodiment are formed with a pyramid-textured structure through an alkali texturing process, and the pyramid has a size of 0.5µm to 3µm.

### 2. Boron diffusion

Referring to FIG. 9c, a first doped layer (i.e., a P+emitter) 11, which is P-type doped, is formed on the first surface S1 of the silicon substrate 10 by a boron diffusion process. Specifically, diffusion is performed in a high-temperature furnace tube using a boron source (such as BCl₃ or BBr₃) deposition and propulsion method. Optionally, a layer of silicon oxide is formed on the outer surface. The first doped layer 11 obtained after this diffusion has a doping concentration of 3E18cm⁻³ to 3E19cm⁻³, and has a square resistance of 40Ω/sq to 300Ω/sq, preferably 150Ω/sq to 250Ω/sq. In the boron diffusion process, a BSG (not shown) is formed on the second surface S2 of the silicon substrate 10.

In this embodiment, the outer silicon layer of the first surface S1 of the silicon substrate 10 is transformed into a boron diffusion layer. In FIG. 9c, the total thickness of the silicon substrate 10 and the first doped layer 11 after boron diffusion is equal to the thickness of the silicon substrate 10 before boron diffusion in FIG. 9b.

### 3. Back surface polishing

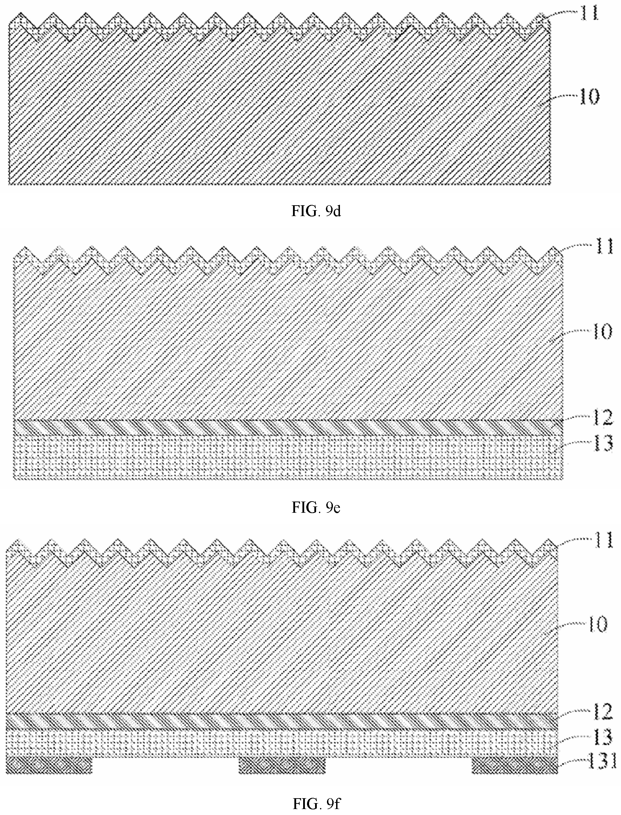

Referring to FIG. 9d, the silicon substrate 10 obtained after boron diffusion firstly passes through a single-sided chain device to remove the silicon oxide on the back surface using a hydrofluoric acid solution. and then the back surface is subject to alkali polishing to remove edge knots and a back surface wraparound (BSG), and finally cleaning is performed.

### 4. Preparation of tunneling and passivation structure on the back surface

As shown in FIG. 9e, a tunneling layer 12 and a second doped layer 13 stacked in sequence are prepared on the second surface S2.

As an example, in this embodiment, a silicon oxide layer as a tunneling layer is firstly deposited on the back surface using a PECVD process. The silicon oxide layer has a thickness of 1nm to 3nm. Then, a layer of phosphorus-doped amorphous silicon or multiple layers of phosphorus-doped amorphous silicon with different doping concentrations is/are deposited, with a total thickness of 1nm to 150nm, preferably 50nm to 100nm.

### 5. Laser oxidation

As shown in FIG. 9f, a laser process is used to treat the second doped layer 13 on the first region S21, recrystallizing the second doped layer 13 on the first region S21 and forming an oxide layer 131 (also known as a mask) on the surface of the second doped layer 13 on the first region S21.

In this embodiment, the second doped layer 13 before treated by the laser process is a phosphorus-doped amorphous silicon layer. The laser process can crystallize the phosphorus-doped amorphous silicon layer on the first region S21, activating the phosphorus and transforming the phosphorus-doped amorphous silicon layer into a phosphorus-doped polysilicon layer. Simultaneously, utilizing the instantaneous high temperature of the laser, a silicon oxide (SiOx) layer is formed on the surface of the phosphorus-doped polysilicon layer in the first region S21. This silicon oxide layer serves as a mask for subsequent processes.

Specifically, the laser process is performed in an atmosphere containing oxygen, with an oxygen volume concentration of 20% to 80%. The laser power is 1W to 100W, preferably 30W to 60W. The laser frequency is 1kHz to 1000kHz, preferably 300kHz to 600kHz. The laser scanning rate is 10000mm/s to 100000mm/s, preferably 30000mm/s to 60000mm/s. The number of laser processing times is 1 to 100, preferably 1 to 10. After the laser process treatment, the surface doping concentration of the second doped layer 13 is 2E20cm⁻³ to 3E21cm⁻³, preferably 5E20cm⁻³ to 2E21cm⁻¹, and the thickness of the formed oxide layer 131 is 1nm to 50nm.

Exemplarily, in one specific embodiment, the volume concentration of oxygen in the laser process is 50%, the laser power is 50W, the laser frequency is 500kHz, the laser scanning rate is 50000mm/s, and the number of laser processing times is 2. The surface doping concentration of the phosphorus-doped amorphous silicon layer is 9E20cm⁻³, and the thickness of the silicon oxide layer formed by surface oxidation of the phosphorus-doped amorphous silicon layer is 0.01nm to 10nm.

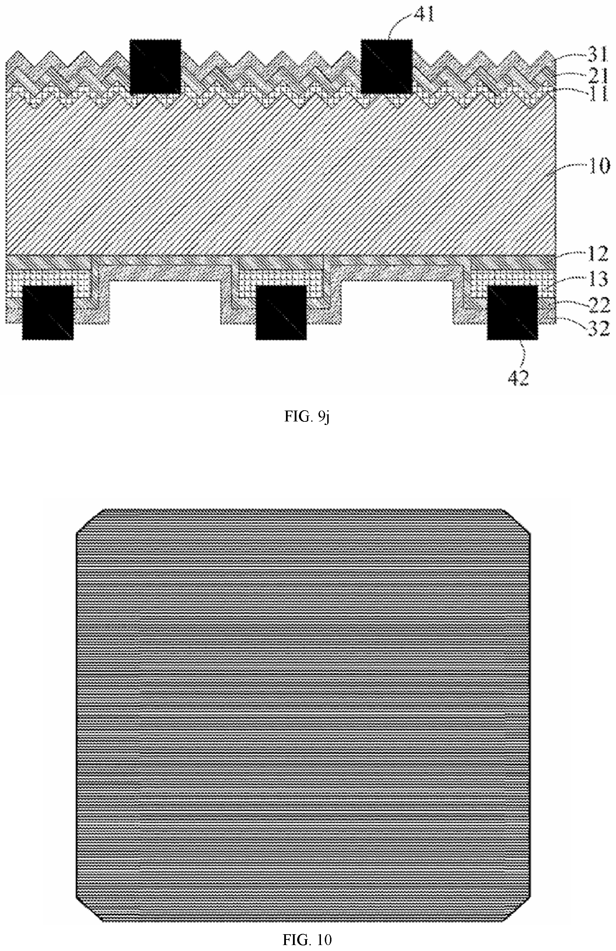

FIG. 10 is the laser scanning pattern in the laser process of this embodiment. The black line portions correspond to the laser scanning areas, i.e., the first regions S21 (i.e., metal regions). The blank portions are the second regions S22 (i.e., non-metal regions). After the laser process, the structure on the first region S21 is: tunneling layer + phosphorus-doped polysilicon layer + silicon oxide layer. The structure on the second region is: tunneling layer + phosphorus-doped amorphous silicon layer.

It should be understood that the laser scanning pattern in the present disclosure can be designed according to different electrode structures, so as to crystallize the amorphous silicon layer below the laser scanning region (i.e., back-side metal region) and form a patterned silicon oxide mask. Laser scanning patterns for other electrode structures are not exhaustively illustrated here.

In the prior art, high-temperature annealing is usually used to convert a doped amorphous silicon layer into a doped polysilicon layer. In that case, a mask layer needs to be separately deposited using processes such as PECVD, and the mask must be patterned. In the present disclosure, a single-step laser process achieves both the conversion of doped amorphous silicon to doped polysilicon and the preparation of a patterned mask, greatly simplifying the process flow.

### 6. Removing wraparound and chemical etching

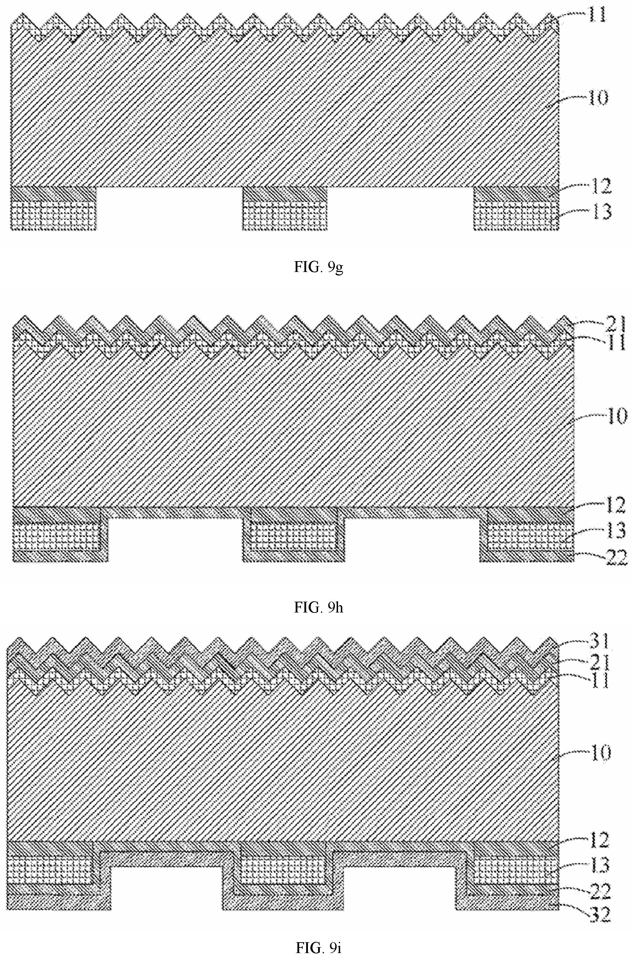

Referring to FIG. 9g, a chemical etching process is used to remove all of the tunneling layer 12 and the second doped layer 13 on the second region S22, as well as the oxide layer 131 on the first region S21, while retaining the tunneling layer 12 and the second doped layer 13 on the first region S21.

The step specifically includes the following operations.

Alkali etching: for example, the entire second doped layer 13 on the second region S22 is removed using an alkali solution in an alkali pickling tank, while front-side and edge wraparound is also removed. The alkali solution has a mass fraction of 3% to 15%, and the treatment time duration is 100s to 500s, preferably 350s.

Acid pickling: for example, the tunneling layer 12 on the second region S22 and the oxide layer 131 on the first region S21 are removed using an acid solution in an acid pickling tank, while PSG on the front side is also removed. The acid solution has a mass fraction of 5% to 20%, and the treatment time duration is 100s to 500s, preferably 300s.

Finally, RCA cleaning is performed. RCA cleaning is a conventional technique and is not described in detail here.

Preferably, the acid solution in this embodiment is obtained by mixing industrial-grade hydrofluoric acid solution (the mass fraction is 40%) with water in a certain ratio. The alkali solution is obtained by mixing industrial-grade sodium hydroxide solution (the mass fraction is 32%) with water in a certain ratio.

In the prior art, a front-side in-line step (acid washing) is usually required before the alkali etching step, i.e., passing through an in-line hydrofluoric acid tank to remove the silicon oxide mask wrapped around the edge. However, in the present disclosure, the silicon oxide mask is not prepared by a PECVD process, so wraparound does not form at the edges. Therefore, the front-side in-line step is not necessary.

During the alkali etching process, the second doped layer 13 (i.e., phosphorus-doped amorphous silicon layer) on the second region S22 is corroded away, which can reduce parasitic absorption on the back surface of the cell, significantly improving the current. The first region S21 are protected by the silicon oxide layer, preventing corrosion by the alkali solution, thereby not affecting the contact performance between the back electrode and the second doped layer.

It should be noted that during the acid pickling process to remove the tunneling layer 12 on the second region S22 and the oxide layer 131 on the first region S21, the silicon substrate 10 in the second region S22 is also slightly etched away. Therefore, the silicon substrate 10 in the second region S22 is slightly thinner than the silicon substrate 10 in the first region S21. In other words, after this acid pickling step, the silicon substrate 10 in the second region S22 is recessed towards the first surface S1 compared to the silicon substrate 10 in the first region S21.

### 7. Preparing a passivation layer

Referring to FIG. 9h, an ALD process is used to prepare a first passivation layer 21 and a second passivation layer 22 on the first surface S1 and the second surface S2 of the silicon substrate 10, respectively. Both the first passivation layer 21 and the second passivation layer 22 are aluminum oxide passivation layers, and have a thickness of 2nm to 7nm, preferably 3nm to 6nm.

After the steps of removing wraparound and chemical etching, the tunneling layer and the doped polysilicon layer on the first region S21 can still ensure passivation performance. However, the second region S22 lacks the protection of a passivation layer. Therefore, while preparing the first passivation layer 21 on the front side, it is necessary to simultaneously prepare the second passivation layer 22 on the back side, thereby ensuring good interface passivation performance on the second region S22.

Furthermore, under the high-temperature sintering conditions that ensure good front-side contact, the second passivation layer 22 has a certain blocking effect on the back-side paste. Therefore, the second doped layer 13 can be further thinned, thereby increasing the short-circuit current density of the cell.

### 8. Preparing a anti-reflection layer

Referring to FIG. 9i, a PECVD process is used to prepare a first anti-reflection layer 31 and a second anti-reflection layer 32 on the first surface S1 and the second surface S2 of the silicon substrate 10, respectively. Each of the first anti-reflection layer 31 and the second anti-reflection layer 32 can be a film formed of any one of a silicon nitride layer, a silicon oxynitride layer, and a silicon oxide layer or a stacked film formed of two or more of a silicon nitride layer, a silicon oxynitride layer, and a silicon oxide layer, and has a thickness of 60nm to 130nm.

### 9. Printing metal electrode

Referring to FIG. 9j, a first electrode 41 and a second electrode 42 are printed, by a screen-printing process, on the front surface and the back surface respectively, and then sintering and optical or electric injection are performed to form an ohmic contact.

The first electrode 41 and the second electrode 42 are grid line electrodes in the prior art, and each typically includes a main grid line and a fine grid line. It is worth noting that since the fine grid line in the second electrode 42 needs to be printed on the first region, the width of the first sub-region 101 needs to be larger than the width of the fine grid line in the second electrode 42, so that correct orientation of the fine grid line can be realized.

A TOPCon cell can be prepared through the above steps, and finally the cell is tested, sorted and put in storage.

### Embodiment 4:

The structure of the solar cell and the method for preparing the solar cell in this embodiment are substantially the same as those in embodiment 3, except that the first doped layer 11 in Embodiment 3 is prepared below the first surface S1 of the silicon substrate (i.e., inside the silicon substrate) by a boron diffusion process, whereas in this embodiment, the first doped layer 11 is prepared above the first surface S1 of the silicon substrate (i.e., outside the silicon substrate) by a PECVD process.

In this embodiment, the specific PECVD process is identical to the PECVD process in Embodiment 2 and will not be repeated here.

It should be understood that in other embodiments, the first doped layer 11 could similarly be prepared by a PECVD process. The specific PECVD process is identical to the PECVD process in Embodiment 2 and will not be repeated here.

### Embodiment 5:

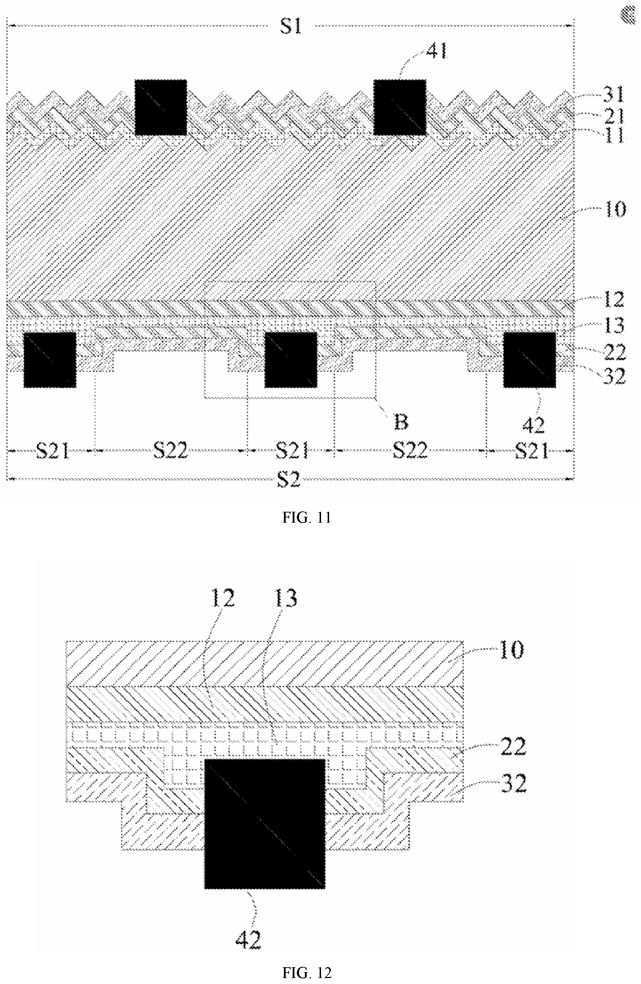

FIG. 11 is a schematic structural diagram of a solar cell in this embodiment. The solar cell is a TOPCon cell. In conjunction with FIG. 12, the back-side structure of the solar cell in this embodiment differs from those of the solar cells in Embodiments 1 to 4. Specifically, the structure on the first region S21 (metal region) is the same. However, the structure on the second region S22 (non-metal region) includes a tunneling layer 12, a second doped layer 13, a second passivation layer 22, and a second anti-reflection layer 32 stacked in sequence, but the thickness of the second doped layer 13 on the second region S22 is less than the thickness of the second doped layer 13 on the first region S21.

The method for preparing the solar cell in this embodiment is similar to that in embodiment 3, except that the wraparound removal and chemical etching process in step 6 is different from those in Embodiment 3. In this embodiment, a chemical etching process is used to remove a part of the second doped layer 13 on the second region S22 and the oxide layer 131 on the first region S21, while retaining the tunneling layer 12 and the second doped layer 13 on the first region S21, and also retaining the tunneling layer 12 and a part of the second doped layer 13 on the second region S22.

This step specifically includes the following operations.

Alkali etching: an alkali solution is used to remove a part of the second doped layer 13 on the second region S22, while front-side wraparound and edge wraparound are also removed. Alkali etching can be used to remove a part of the second doped layer 13 by adjusting process parameters, such as shortening the alkali etching time or reducing the alkali solution mass fraction, which will not be described in detail here.

Acid pickling: an acid solution is used to remove the oxide layer 131 on the first region S21, while PSG on the front side is also removed.

Finally, RCA cleaning is performed.

It should be understood that in this embodiment, the second doped layer 13 on the first region S21 is a doped polysilicon layer after laser process treatment, while the part of the second doped layer 13 retained on the second region S21 is a doped amorphous silicon layer that has not undergone laser process treatment.

It can be seen from the above technical solutions that the present disclosure has the following beneficial effects.

The preparation process for the back-side SE (Selective Emitter) structure of the cell in the present disclosure is simple. A single-step laser process can complete the oxidation and crystallization of the first region (metal region), eliminating the need for mask fabrication steps, annealing steps, and the front-side in-line step before wraparound removal in the polysilicon process.

Furthermore, in the present disclosure, the doped layer in the second region (non-metal region) on the back side of the cell is completely removed, while the doped layer in the first region (metal region) remains unaffected. This makes it possible to achieve both a passivation effect and a reduction in parasitic absorption without changing the paste, thereby significantly improving the cell efficiency and bifaciality while increasing the process window.

It is apparent to those skilled in the art that the present disclosure is not limited to the details of the exemplary embodiments described above, and that the present disclosure is capable of being realized in other specific forms without departing from the spirit or essential features of the present disclosure. Accordingly, the embodiments should be viewed as exemplary and non-limiting in any point of view, and the scope of the present disclosure is limited by the appended claims rather than by the foregoing description, and is therefore intended to encompass all variations falling within the meaning and scope of the equivalent elements of the claims. Any reference numbers in the claims should not be regarded as limiting the claims to which they relate.

In addition, it should be understood that although this specification is described in accordance with the embodiments, not each embodiment contains only one independent technical solution, and this description of the specification is only for the sake of clarity. The person skilled in the art should take the specification as a whole, and the technical solutions in the various embodiments may be combined appropriately to form other embodiments that can be understood by the person skilled in the art.

## Claims

1. A method for preparing a solar cell, comprising:
providing a silicon substrate, the silicon substrate comprising a first surface and a second surface that are disposed opposite to each other, the second surface comprising a first region and a second region distributed at intervals;
forming a tunneling layer and a second doped layer that are stacked on the first region;
preparing a second passivation layer on the second region and the second doped layer, the second passivation layer being in contact with the silicon substrate on the second region; and
preparing a second electrode on the first region, the second electrode being in contact with the second doped layer.

2. The method for preparing the solar cell according to claim 1, wherein said forming the tunneling layer and the second doped layer that are stacked on the first region comprises:
sequentially preparing the tunneling layer, the second doped layer, and a mask on the second surface;
removing the mask on the second region; and
removing the second doped layer and the tunneling layer on the second region, and retaining the tunneling layer and the second doped layer on the first region.

3. The method for preparing the solar cell according to claim 2, wherein the mask on the second region is removed by a laser film patterning process; and
the second doped layer and the tunneling layer on the second region are removed by a chemical etching process.

4. The method for preparing the solar cell according to claim 2 or 3, wherein said sequentially preparing the tunneling layer, the second doped layer, and the mask on the second surface comprises:
sequentially depositing the tunneling layer, a doped amorphous silicon layer, and the mask on the second surface of the silicon substrate; and
annealing the silicon substrate deposited with the tunneling layer, the doped amorphous silicon layer and the mask, so as to transform the doped amorphous silicon layer into a doped polysilicon layer.

5. The method for preparing the solar cell according to any one of claims 2 to 4, further comprising:
preparing a light-trapping structure on the first surface and the second surface of the silicon substrate via a texturing process; and/or
performing a polishing process on the second surface of the silicon substrate before preparing the tunneling layer, the second doped layer, and the mask.

6. The method for preparing the solar cell according to claim 1, wherein said forming the tunneling layer and the second doped layer that are stacked on the first region comprises:
sequentially preparing the tunneling layer and the second doped layer on the second surface;
treating the second doped layer on the first region to crystallize the second doped layer on the first region, and forming an oxide layer on a surface of the second doped layer on the first region, the oxide layer serving as a mask; and
removing the second doped layer and the tunneling layer on the second region, and removing the oxide layer on the first region, and retaining the tunneling layer and the second doped layer on the first region.

7. The method for preparing the solar cell according to claim 6, wherein the second doped layer on the first region is treated by a laser process, and the second doped layer and the tunneling layer on the second region, and the oxide layer on the first region are removed by a chemical etching process.

8. The method for preparing the solar cell according to claim 7, wherein the second doped layer before treated by the laser process is a doped amorphous silicon layer, and the laser process crystallizes the doped amorphous silicon layer on the first region to transform the doped amorphous silicon layer into a doped polysilicon layer, and simultaneously a silicon oxide layer is formed on the surface of the second doped layer on the first region, the silicon oxide layer serving as the mask.

9. The method for preparing the solar cell according to claim 8, wherein the chemical etching process comprises:
using the silicon oxide layer as the mask, removing all the doped amorphous silicon layer on the second region, and then removing the tunneling layer on the second region and the silicon oxide layer on the first region.

10. The method for preparing the solar cell according to any one of claims 6 to 9, further comprising:
preparing a light-trapping structure on the first surface and the second surface of the silicon substrate via a texturing process; and/or
performing a polishing process on the second surface of the silicon substrate before preparing the tunneling layer and the second doped layer.

11. A solar cell, comprising a silicon substrate, wherein the silicon substrate comprises a first surface and a second surface that are disposed opposite to each other, the second surface comprises a first region and a second region distributed at intervals; a tunneling layer in direct contact with the silicon substrate, a second doped layer disposed on the tunneling layer, and a second electrode are provided on the first region, a second passivation layer in contact with the second surface of the silicon substrate is provided on the second region, and the second electrode is in contact with the second doped layer.

12. The solar cell according to claim 11, wherein the second passivation layer extends onto the first region and covers the tunneling layer and the second doped layer.

13. The solar cell according to claim 11 or 12, wherein the second passivation layer is an aluminum oxide passivation layer having a thickness of 2nm to 7nm, or 3nm to 6nm, or 3nm to 5nm.

14. The solar cell according to any one of claims 11 to 13, wherein a second anti-reflection layer is stacked on the second passivation layer, and the second anti-reflection layer is a film formed of any one of a silicon nitride layer, a silicon oxynitride layer, and a silicon oxide layer or a stacked film formed of two or more of a silicon nitride layer, a silicon oxynitride layer, and a silicon oxide layer, and has a thickness of 60nm to 130nm.

15. The solar cell according to any one of claims 11 to 14, wherein a doping type of the second doped layer is the same as a doping type of the silicon substrate, the silicon substrate is an N-type silicon substrate, and the second doped layer is an N-type doped polysilicon layer; and/or
the second doped layer has a surface doping concentration of 1E20cm⁻³ to 1E21cm⁻³, and a thickness of 1nm to 150nm, or 50nm to 100nm, or 80nm to 100nm.

16. The solar cell according to any one of claims 11 to 15, wherein the tunneling layer is one or a combination of a silicon oxide layer and a silicon oxynitride layer, and has a thickness of 0.5nm to 3nm, or 1.5nm to 2.5nm.

17. The solar cell according to any one of claims 11 to 16, wherein a first doped layer and a first electrode are formed at the first surface of the silicon substrate, a doping type of the first doped layer is opposite to the doping type of the silicon substrate, and the first electrode is in contact with the first doped layer.

18. The solar cell according to claim 17, wherein a first passivation layer and/or a first anti-reflection layer are stacked on the first doped layer;
the first passivation layer is an aluminum oxide passivation layer having a thickness of 2nm to 7nm, or 3nm to 6nm; and/or
the first anti-reflection layer is a film formed of any one of a silicon nitride layer, a silicon oxynitride layer, and a silicon oxide layer or a stacked film formed of two or more of a silicon nitride layer, a silicon oxynitride layer, and a silicon oxide layer, and has a thickness of 60nm to 130nm.

19. The solar cell according to any one of claims 11 to 18, wherein the first region comprise a plurality of first sub-regions that are distributed in parallel and at equal intervals, the second electrode comprises a plurality of grid lines distributed in parallel, and a width of the first sub-region is greater than or equal to a width of the grid line.

20. A photovoltaic module, wherein the photovoltaic module comprises the solar cell prepared by the method according to any one of claims 1 to 10, or the solar cell according to any one of claims 11 to 19.
